# EUROPEAN PATENT SPECIFICATION

(11) **EP 4 564 032 B1**
(45) Date of publication and mention of the grant of the patent: **28.10.2026**
(21) Application number: 23846887.0
(22) Date of filing: 17.07.2023
(51) Int. Cl.: G01R 31/371, G01R 23/00, G01R 31/389, G01R 31/3842, G01R 31/396, G08C 17/02, H01M 10/48, B60L 58/10

(54) **BATTERY MANAGEMENT DEVICE AND OPERATING METHOD THEREOF**
BATTERIEVERWALTUNGSVORRICHTUNG UND BETRIEBSVERFAHREN DAFÜR
DISPOSITIF DE GESTION DE BATTERIE ET SON PROCÉDÉ DE FONCTIONNEMENT

(30) Priority: 28.07.2022 KR 20220094265
(43) Date of publication of application: 04.06.2025
(73) Proprietor: LG Energy Solution, Ltd., Seoul 07335 (KR)
(72) Inventor: YU, Jae Wook, Daejeon 34122 (KR)
(74) Representative: Goddar, Heinz J.
(86) International application number: PCT/KR2023/010215
(87) International publication number: WO 2024/025228

(56) References cited:
- EP-B1- 2 980 912
- JP-A- 2002 084 207
- JP-A- 2019 527 528
- JP-B2- 6 032 025
- JP-B2- 6 905 985
- KR-A- 20180 010 869
- US-A1- 2018 364 311
- US-A1- 2022 074 997

## Description

### [TECHNICAL FIELD]

### TECHNICAL FIELD

Embodiments disclosed herein relate to a battery management apparatus and an operating method thereof.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Wireless BMS technology refers to technology that wirelessly implements existing controller area network (CAN) communication or Daisy chain communication where a slave BMS monitors multiple battery cell stacks to transmit information to a master BMS.

The BMS generally determines a state of a battery cell by measuring time, temperature, voltage, current, etc., required during repetition of charge and discharge. However, detailed characteristics inside the battery cell may not be reflected merely with temperature, voltage, and current.

US 2018/364311 A1 discloses a system for portable or handheld measuring of a characteristic of batteries or other energy storage devices, in particular, for measuring a characteristic of high voltage batteries, e.g. to kV and/or automotive batteries as used in electric or hybrid automobiles or vehicles. The system is used to perform a battery diagnostic test, for example on high voltage batteries, e.g. to kV and/or automotive batteries as used in electric or hybrid automobiles. One such characteristic or diagnostic parameter is the impedance of such batteries and one such method is impedance spectroscopy testing.

EP 2 980 912 A1 observers that communication distance can be extended in a battery system that transmits states of the battery cells by wireless communication. Each of cell controllers wirelessly transmits measurement result of states of battery cells in cell groups to a battery controller, by using an electric power supplied from the battery cells in the cell groups. The battery controller continuously transmits unmodulated carrier wave to each of the cell controllers. Each of the cell controllers changes an impedance for the unmodulated carrier wave transmitted from the battery controller at a predetermined timing in dependence on the measurement result of the states of the battery cells in the cell groups. Due to this, the measurement result of the states of the battery cells in the cell groups is wirelessly transmitted to the battery controller.

US 2022/074997 A1 discloses a wireless battery management system that includes a network controller and a plurality of monitors coupled to a battery. The wireless battery management system may coordinate taking and gathering of alternating current frequency responses (ACFR) of the battery. The wireless battery management system may collect and store information spanning the lifecycle of the battery across different host devices.

### [SUMMARY]

### [TECHNICAL PROBLEM]

Embodiments disclosed herein aim to provide a battery management apparatus and an operating method thereof in which detailed characteristics inside a battery, which are not reflected by voltage, current, and temperature, may be measured and diagnosed.

Embodiments disclosed herein aim to provide a battery management apparatus and an operating method thereof in which when a wireless BMS is used, a battery cell may be diagnosed based on RF characteristics to predict a failure of a battery cell and achieve safety of the battery cell.

Technical problems of the embodiments disclosed herein are not limited to the above-described technical problems, and other unmentioned technical problems would be clearly understood by one of ordinary skill in the art from the following description.

### [TECHNICAL SOLUTION]

A battery management apparatus according to an embodiment disclosed herein includes a communication unit configured to transmit a first signal to a battery cell, a switch configured to connect the communication unit to the battery cell, and a controller configured to control an operation of the switch, receive a second signal corresponding to the first signal, and diagnose a state of the battery cell based on the second signalThe communication unit is connected to the battery cell or an antenna based on an operation of the switch. The controller is further configured to control the operation of the switch to allow the communication unit to be connected to the antenna when communication with a battery cell monitoring device is performed, and to control the operation of the switch to allow the communication unit to be connected to the battery cell when communication with the battery cell monitoring device is not performed.

In an embodiment, the first signal and the second signal may be RF signals, and the second signal may be a reflected signal of the first signal.

In an embodiment, the controller may be further configured to diagnose the state of the battery cell by comparing the second signal with a signal related to a battery cell in a normal state.

In an embodiment, the communication unit may be further configured to transmit a first signal having different transmission powers, and the controller may be further configured to transmit a second signal corresponding to the different transmission powers and diagnose the state of the battery cell based on the second signal corresponding to the different transmission powers.

In an embodiment, the communication unit may be further configured to transmit a first signal comprising different frequencies, and the controller may be further configured to receive a second signal corresponding to the different frequencies and diagnose the state of the battery cell based on the second signal corresponding to the different frequencies.

In an embodiment, the controller may be further configured to diagnose at least any one of an impedance, a sensitivity change, a peak error rate (PER) change, a saturation level, and a received signal strength indication (RSSI) of the battery cell based on the second signal.

In an embodiment, the controller may be further configured to receive a third signal including voltage, current, and temperature information from the battery cell and diagnose the state of the battery cell based on the second signal and the third signal.

In an embodiment, the communication unit may be further configured to transmit the first signal when communication with the battery cell monitoring device is not performed.

In an embodiment, the communication unit may be further configured to transmit the first signal when the switch is connected to the battery cell.

In an embodiment, the communication unit may be further configured to perform wireless communication with a battery cell monitoring device through a radio frequency (RF) signal.

In an embodiment, the communication unit may be further configured to perform the wireless communication when the switch is connected to the antenna.

An operating method of a battery management apparatus according to an embodiment disclosed herein includes transmitting, by a communication unit, a first signal to a battery cell, receiving, by a controller, a second signal corresponding to the first signal, and diagnosing, by the controller, a state of the battery cell based on the second signal, in which the controller is connected to the communication unit through a switch, and the switch connects the communication unit to the battery cell. The operating method further includes controlling the operation of the switch to allow the communication unit to be connected to the antenna when communication with a battery cell monitoring device is performed and controlling the operation of the switch to allow the communication unit to be connected to the battery cell when communication with the battery cell monitoring device is not performed.

In an embodiment, the diagnosing, by the controller, of the state of the battery cell based on the second signal may include diagnosing the state of the battery cell by comparing the second signal with a signal related to a battery cell in a normal state.

### [ADVANTAGEOUS EFFECTS]

A battery management apparatus and an operating method thereof according to an embodiment disclosed herein may measure information related to an impedance through an RF signal to measure and diagnose detailed characteristics inside a battery, which are not reflected by characteristics such as a voltage, a current, and a temperature.

The battery management apparatus and the operating method thereof according to an embodiment disclosed herein may diagnose a state of a battery cell by transmitting an RF signal to a battery cell and receiving a signal corresponding thereto when wireless communication is not performed.

The battery management apparatus and the operating method thereof according to an embodiment disclosed herein may control a switch according to whether to use the RF signal for wireless communication or for diagnosing the battery cell.

The battery management apparatus and the operating method thereof according to an embodiment disclosed herein may measure information related to an impedance to diagnose the battery cell through an RFIC for wireless communication without adding another device.

Moreover, various effects recognized directly or indirectly from the disclosure may be provided.

### [DESCRIPTION OF DRAWINGS]

FIG. 1 is a block diagram showing a configuration of a battery pack according to an embodiment disclosed herein.
FIG. 2 is a block diagram showing a battery management apparatus and a battery cell, according to an embodiment disclosed herein.
FIG. 3 is a view showing an example of transmitting an RF signal and receiving a corresponding signal, by a battery management apparatus according to an embodiment disclosed herein.
FIG. 4 is a flowchart showing an operating method of a battery management apparatus according to an embodiment disclosed herein.
FIG. 5 is a flowchart showing in detail an operating method of a battery management apparatus according to an embodiment disclosed herein.
FIG. 6 is a block diagram showing a hardware configuration of a computing system for performing an operating method of a battery management apparatus, according to an embodiment disclosed herein.

### [DETAILED DESCRIPTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

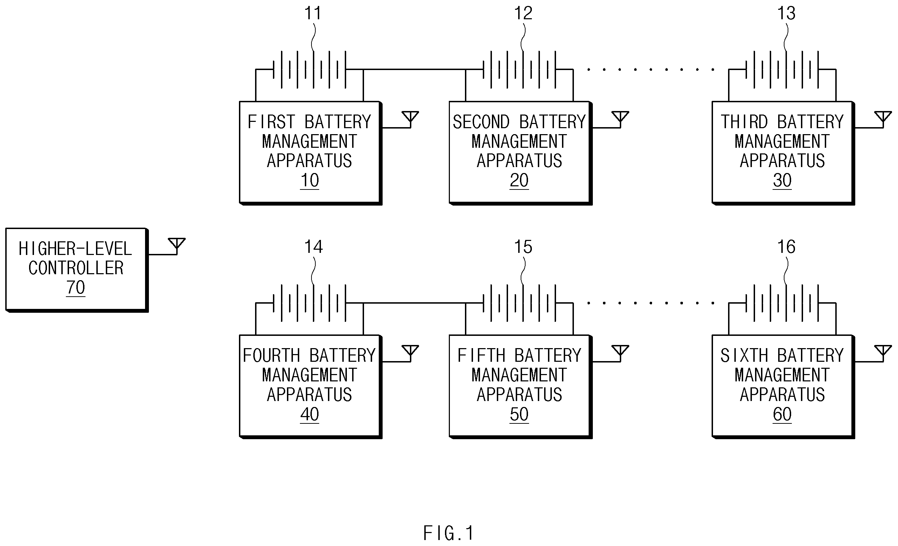

FIG. 1 is a block diagram showing a configuration of a battery pack according to an embodiment disclosed herein.

Referring to FIG. 1, a battery pack 1 according to an embodiment disclosed herein may include battery cells 11, 12, 13, 14, 15, and 16, battery management apparatuses 10, 20, 30, 40, 50, and 60, and a higher-level controller 70.

The battery cells 11, 12, 13, 14, 15, and 16 may include a first battery cell 11, a second battery cell 12, a third battery cell 13, a fourth battery cell 14, a fifth battery cell 15, and a sixth battery cell 16. According to an embodiment, each of the first battery cell 11, the second battery cell 12, the third battery cell 13, the fourth battery cell 14, the fifth battery cell 15, and the sixth battery cell 16 may include one battery cell or a plurality of battery cells. Although the battery pack 1 is illustrated as including six battery cells 11, 12, 13, 14, 15, and 16 in FIG. 1, the present disclosure is not limited thereto, and the battery pack 1 may include one battery cell or n battery cells (n is a natural number).

The battery management apparatuses 10, 20, 30, 40, 50, and 60 may include a first battery management apparatus 10, a second battery management apparatus 20, a third battery management apparatus 30, a fourth battery management apparatus 40, a fifth battery management apparatus 50, and a sixth battery management apparatus 60. According to an embodiment, the battery management apparatuses 10, 20, 30, 40, 50, and 60 may receive measured values of voltage, current, and temperature of corresponding respective battery cells 11, 12, 13, 14, 15, and 16, and include a plurality of terminals, a circuit connected to the terminals to process the received values, etc. The battery management apparatuses 10, 20, 30, 40, 50, and 60 may control on/off of a relay, a contactor, etc., and may be connected to the battery cells 11, 12, 13, 14, 15, and 16 to monitor the state of each of the battery cells 11, 12, 13, 14, 15, and 16. Although the battery pack 1 is illustrated as including six battery management apparatuses 10, 20, 30, 40, 50, and 60 in FIG. 1, the present disclosure is not limited thereto, and the battery pack 1 may include one battery management apparatus or m battery management apparatuses (m is a natural number).

The battery management apparatuses 10, 20, 30, 40, 50, and 60 includes a wireless communication unit. For example, the wireless communication unit may be implemented as an antenna. In another example, the wireless communication unit may include an RFIC. The battery management apparatuses 10, 20, 30, 40, 50, and 60 may perform wireless communication with the higher-level controller 70 through the wireless communication unit based on a radio frequency (RF) signal. For example, the battery management apparatuses 10, 20, 30, 40, 50, and 60 may transmit information about a battery cell (e.g., voltage, current, temperature, etc., of a battery cell) to the higher-level controller 70 through the wireless communication unit. According to an embodiment, the battery management apparatuses 10, 20, 30, 40, 50, and 60 may be slave BMSs, and the higher-level controller 70 may be a master BMS.

The higher-level controller 70 may transmit a control signal regarding the battery cells 11, 12, 13, 14, 15, and 16 to the battery management apparatuses 10, 20, 30, 40, 50, and 60. Thus, the battery management apparatuses 10, 20, 30, 40, 50, and 60 may also be controlled in terms of an operation thereof based on a signal applied from the higher-level controller 70.

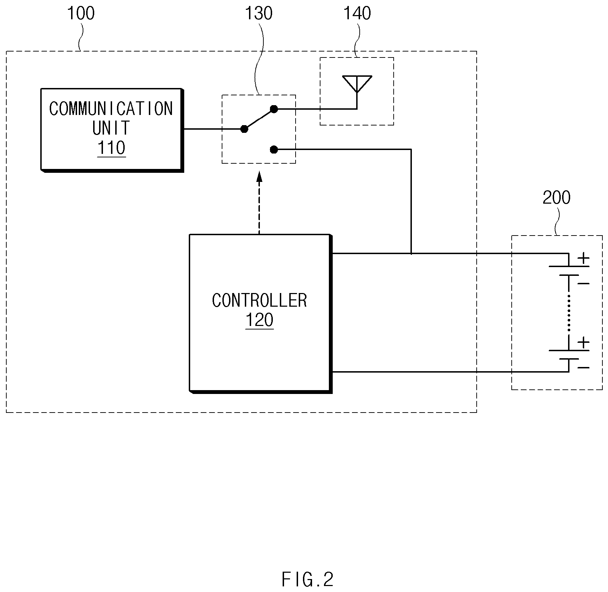

According to an embodiment, each of the battery management apparatuses 10, 20, 30, 40, 50, and 60 may be substantially the same as the battery management apparatus 100 of FIG. 2. Each of the battery cells 11, 12, 13, 14, 15, and 16 may be substantially the same as a battery cell 200 of FIG. 2.

FIG. 2 is a block diagram showing a battery management apparatus and a battery cell, according to an embodiment disclosed herein.

Referring to FIG. 2, the battery management apparatus 100 according to an embodiment disclosed herein may include a communication unit 110, a controller 120, a switch 130, and an antenna 140.

The communication unit 110 may perform wireless communication with a battery cell monitoring device through an RF signal. For example, the communication unit 110 may perform wireless communication with the battery cell monitoring device by transmitting an RF signal through the switch 130 and the antenna 140. According to an embodiment, the battery cell monitoring device may include the higher-level controller 70 of FIG. 1. According to an embodiment, the communication unit 110 may include an RFIC.

The controller 120 may be connected to the battery cell 200. The controller 120 may be connected to the communication unit 110 through the switch 130. According to an embodiment, the controller 120 may control an operation of the switch 130.

The switch 130 may connect the communication unit 110 to the battery cell 200. The switch 130 may connect the communication unit 110 to the antenna 140. That is, the communication unit 110 may be connected to any one of the battery cell 200 and the antenna 140 based on an operation of the switch 130.

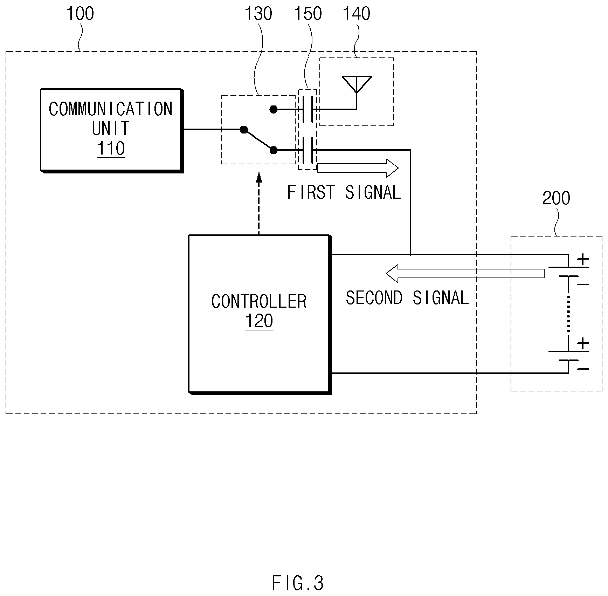

FIG. 3 is a view showing an example of transmitting an RF signal and receiving a corresponding signal, by a battery management apparatus according to an embodiment disclosed herein.

Referring to FIG. 3, the controller 120 may receive a second signal corresponding to a first signal transmitted from the communication unit 110 to the battery cell through the switch 130. In this case, the switch 130 may connect the communication unit 110 to the controller 120 and the battery cell 200. According to an embodiment, the first signal and the second signal may be RF signals, and the second signal may be a reflected signal of the first signal.

According to an embodiment, the battery management apparatus 100 may include a plurality of capacitors 150. For example, the capacitor 150 may be included between the switch 130 and the antenna 140 to transmit an RF signal. In another example, the capacitor 150 may be included between the switch 130 and the battery cell 200 to transmit an RF signal. According to another embodiment, a plurality of inductors (not shown) may be further included between the controller 120 and the battery cell 200.

Referring back to FIG. 2, the controller 120 may diagnose a state of the battery cell 200 based on a second signal received corresponding to the first signal transmitted from the communication unit 110. For example, the controller 120 may diagnose a state of the battery cell 200 by comparing the received second signal with a signal related to a battery cell in a normal state. According to an embodiment, the controller 120 may diagnose that the battery cell 200 is not in a normal state, when a difference between the received second signal and the signal related to the battery cell in the normal state is a preset value or more. Thus, the battery management apparatus 100 may accurately diagnose the state of the battery cell 200, which may not be diagnosed in direct current characteristics, based on an alternating current signal (an RF signal, the second signal) received corresponding to an alternating current signal (an RF signal, the first signal) transmitted from the communication unit 110.

According to an embodiment, the controller 120 may diagnose at least any one of an impedance, a sensitivity change, a peak error rate (PER) change, a saturation level, and a received signal strength indication (RSSI) of the battery cell 200 based on the second signal.

According to an embodiment, the signal related to the battery cell in the normal state may be a previously stored value. That is, the battery management apparatus 100 may further include a memory in which the signal related to the battery cell in the normal state may be stored.

According to an embodiment, the controller 120 may receive a third signal including voltage, current, and temperature information from the battery cell 200. In this case, the controller 120 may diagnose the state of the battery cell based on the second signal and the third signal. Thus, the battery management apparatus 100 may diagnose, based on the second signal, the state of the battery cell related to an impedance that is not diagnosed based on the third signal including the voltage, current, and temperature information.

According to an embodiment, the communication unit 110 may be connected to the battery cell 200 or the antenna 140 based on an operation of the switch 130. For example, the communication unit 110 may be connected to the antenna 140 through the switch 130 when communicating with the battery cell monitoring device. In another example, when not communicating with the battery cell monitoring device, the communication unit 110 may be connected to the battery cell 200 and the controller 120 through the switch 130 to allow the controller 120 to diagnose the state of the battery cell 200 through a reflected signal by transmitting an RF signal to the battery cell 200.

According to an embodiment, the communication unit 110 may transmit the first signal when not communicating with the battery cell monitoring device.

According to an embodiment, the communication unit 110 may transmit the first signal when the switch 130 is connected to the battery cell 200. The communication unit 110 may perform wireless communication when the switch 130 is connected to the antenna 140.

According to an embodiment, the controller 120 may control the switch 130. For example, when the communication unit 110 communicates with the battery cell monitoring device, the controller 120 may control an operation of the switch 130 to connect the communication unit 110 to the antenna 140. In another example, when the communication unit 110 does not communicate with the battery cell monitoring device, the controller 120 may control an operation of the switch 130 to connect the communication unit 110 to the battery cell 200.

According to an embodiment, the communication unit 110 may transmit the first signal comprising different transmission powers. For example, the communication unit 110 may transmit the first signal comprising different transmission powers by changing a power of an RFIC. In this case, the controller 120 may receive the second signal corresponding to the different transmission powers and diagnose a state of the battery cell based on the second signal corresponding to the different transmission powers, received for each transmission power. Thus, the battery management apparatus 100 may accurately manage the state of the battery cell 200 based on signals corresponding to various transmission powers.

According to an embodiment, the communication unit 110 may transmit the first signal comprising different frequencies. For example, the communication unit 110 may transmit the first signal comprising different frequencies by changing a frequency of an RFIC. In this case, the controller 120 may receive the second signal corresponding to the different frequencies and diagnose a state of the battery cell based on the second signal corresponding to the different frequencies, received for each frequency. Thus, the battery management apparatus 100 may accurately manage the state of the battery cell 200 based on signals corresponding to various frequencies.

According to an embodiment, the controller 120 may diagnose the state of the battery cell 200 by plotting the second signal corresponding to different transmission powers or frequencies as a graph.

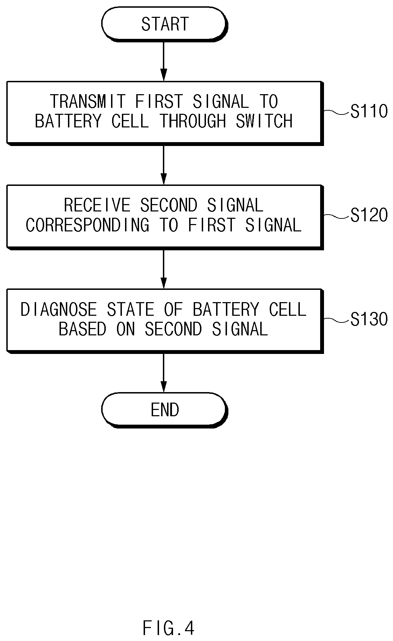

FIG. 4 is a flowchart showing an operating method of a battery management apparatus according to an embodiment disclosed herein. Operations shown in FIG. 4 may be performed by the battery management apparatus 100 and the battery cell 200 shown in FIG. 2.

Referring to FIG. 4, an operating method of the battery management apparatus 100 according to an embodiment disclosed herein may include operation S110 of transmitting a first signal to a battery cell through a switch, operation S120 of receiving a second signal corresponding to the first signal, and operation S130 of diagnosing a state of the battery cell based on the second signal.

In operation S110 of transmitting the first signal to the battery cell through the switch, the communication unit 110 may transmit the first signal to the battery cell 200 through the switch 130. For example, the communication unit 110 may perform wireless communication with the battery cell monitoring device through an RF signal. In another example, the communication unit 110 may perform wireless communication with the battery cell monitoring device by transmitting an RF signal through the switch 130 and the antenna 140.

In operation S120 of receiving the second signal corresponding to the first signal, the controller 120 may receive the second signal corresponding to the first signal transmitted from the communication unit 110. For example, the controller 120 may be connected to the battery cell 200. The controller 120 may be connected to the communication unit 110 through the switch 130. In another example, the first signal and the second signal may be RF signals, and the second signal may be a reflected signal of the first signal.

In operation S130 of diagnosing the state of the battery cell based on the second signal, the controller 120 may diagnose the state of the battery cell based on the received second signal. For example, the controller 120 may diagnose a state of the battery cell 200 by comparing the received second signal with a signal related to a battery cell in a normal state. According to an embodiment, the controller 120 may diagnose that the battery cell 200 is not in a normal state, when a difference between the received second signal and the signal related to the battery cell in the normal state is a preset value or more. Thus, the battery management apparatus 100 may accurately diagnose the state of the battery cell 200, which may not be diagnosed in direct current characteristics, based on an alternating current signal (an RF signal, the second signal) received corresponding to an alternating current signal (an RF signal, the first signal) transmitted from the communication unit 110.

According to an embodiment, in operation S110, the communication unit 110 may transmit the first signal for each transmission power. In another example, the communication unit 110 may transmit the first signal for each transmission power by changing a power of an RFIC. In this case, in operation S130, the controller 120 may receive the second signal for each transmission power and diagnose the state of the battery cell based on the second signal received for each transmission power. Thus, the battery management apparatus 100 may accurately manage the state of the battery cell 200 based on signals of various powers.

According to an embodiment, in operation S110, the communication unit 110 may transmit the first signal for each frequency. For example, the communication unit 110 may transmit the first signal for each frequency by changing a power of an RFIC. In this case, in operation S130, the controller 120 may receive the second signal for each frequency and diagnose the state of the battery cell based on the second signal received for each frequency. Thus, the battery management apparatus 100 may accurately manage the state of the battery cell 200 based on signals of various frequencies.

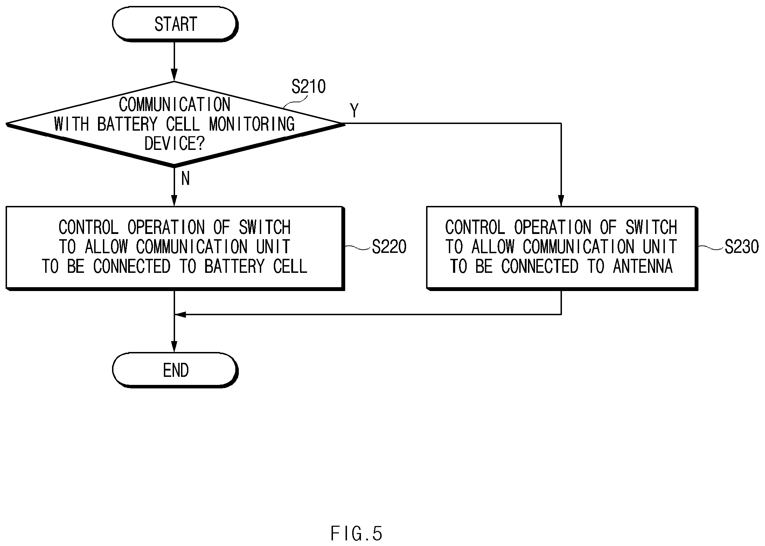

FIG. 5 is a flowchart showing in detail an operating method of a battery management apparatus according to an embodiment disclosed herein.

Referring to FIG. 5, the operating method of the battery management apparatus 100 according to an embodiment disclosed herein may include operation S210 of determining whether communication with the battery cell monitoring device is performed, operation S220 of controlling the switch to be connected to the battery cell when not communicating with the battery cell monitoring device, and operation S230 of controlling the switch to be connected to the antenna when communicating with the battery cell monitoring device.

In operation S210 of determining whether communication with the battery cell monitoring device is performed, the controller 120 may determine whether communication with the battery cell monitoring device is performed through the communication unit 110. For example, the controller 120 may control the switch 130 to connect the communication unit 110 to any one of the antenna 140 or the battery cell 200.

When communication with the battery cell monitoring device is not performed, the controller 120 may control the switch 130 to be connected to the battery cell 200, in operation S220. In this case, the communication unit 110 may transmit the RF signal to the battery cell 200 to allow the controller 120 to diagnose the state of the battery cell 200 through a reflected signal.

When communication with the battery cell monitoring device is performed, the controller 120 may control the switch 130 to be connected to the antenna 140, in operation S230.

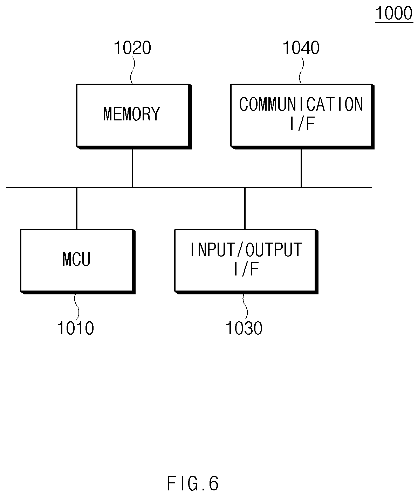

FIG. 6 is a block diagram showing a hardware configuration of a computing system for performing an operating method of a battery management apparatus, according to an embodiment disclosed herein.

Referring to FIG. 6, a computing system 1000 according to an embodiment disclosed herein may include an MCU 1010, a memory 1020, an input/output I/F 1030, and a communication I/F 1040.

The MCU 1010 may be a processor that executes various programs (e.g., a battery pack voltage or current collection program, a wireless communication program, a battery cell state diagnosis program, a battery cell RF signal processing program, a battery cell VIT (voltage, current, temperature) signal processing program, a relay control program, etc.) stored in the memory 1020, processes an RF signal received from a battery cell or various information including current, voltage, temperature information, etc., of the battery cell through these programs, and executes the above-described functions of the battery management apparatus shown in FIG. 2.

The memory 1020 may store various programs such as the wireless communication program of the battery cell, the battery cell state diagnosis program, the battery cell RF signal processing program, the battery cell VIT (voltage, current, temperature) signal processing program, the relay control program, etc. Moreover, the memory 1020 may store various information such as the RF signal received from the battery cell or current, voltage, temperature information, etc., of the battery cell.

The memory 1020 may be provided in plural, depending on a need. The memory 1020 may be volatile memory or non-volatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., to the MCU 1010.

The communication I/F 1040, which is a component capable of transmitting and receiving various data to and from a server, may be various devices capable of supporting wired or wireless communication. For example, the battery management apparatus may transmit and receive the RF signal received from various battery cells or current, voltage, and temperature information of the battery cell from a separately provided external server through the communication I/F 1040.

As such, a computer program according to an embodiment disclosed herein may be recorded in the memory 1020 and processed by the MCU 1010, thus being implemented as a module that performs functions shown in FIG. 2.

## Claims

1. A battery management apparatus (10, 20, 30, 40, 50, 60, 100) comprising:
a communication unit (110) configured to transmit a first signal to a battery cell (11-16, 200);
a switch (130) configured to connect the communication unit (110) to the battery cell (11-16, 200); and
a controller (120) configured to control an operation of the switch (130), receive a second signal corresponding to the first signal, and diagnose a state of the battery cell (11-16, 200) based on the second signal,
**characterized in that** the communication unit (110) is connected to the battery cell (11-16, 200) or an antenna (140) based on an operation of the switch (130),
wherein the controller (120) is further configured to:
control the operation of the switch (130) to allow the communication unit (110) to be connected to the antenna (140) when communication with a battery cell monitoring device (70) is performed; and
control the operation of the switch (130) to allow the communication unit (110) to be connected to the battery cell (11-16, 200) when communication with the battery cell monitoring device (70) is not performed.

2. The battery management apparatus (10, 20, 30, 40, 50, 60, 100) of claim 1, wherein the first signal and the second signal are radio frequency (RF) signals, and the second signal is a reflected signal of the first signal.

3. The battery management apparatus (10, 20, 30, 40, 50, 60, 100) of claim 1 or 2, wherein the controller (120) is further configured to diagnose the state of the battery cell (11-16, 200) by comparing the second signal with a signal related to a battery cell (11-16, 200) in a normal state.

4. The battery management apparatus (10, 20, 30, 40, 50, 60, 100) of claim 1, wherein the communication unit (110) is further configured to transmit a first signal comprises different transmission powers, and
the controller (120) is further configured to:
transmit a second signal corresponding to the different transmission powers; and
diagnose the state of the battery cell (11-16, 200) based on the second signal corresponding to the different transmission powers.

5. The battery management apparatus (10, 20, 30, 40, 50, 60, 100) of claim 1, wherein the communication unit (110) is further configured to transmit a first signal comprises different frequencies, and
the controller (120) is further configured to:
receive a second signal corresponding to the different frequencies; and
diagnose the state of the battery cell (11-16, 200) based on the second signal corresponding to the different frequencies.

6. The battery management apparatus (10, 20, 30, 40, 50, 60, 100) of claim 1, wherein the controller (120) is further configured to diagnose at least any one of an impedance, a sensitivity change, a peak error rate (PER) change, a saturation level, and a received signal strength indication (RSSI) of the battery cell (11-16, 200) based on the second signal.

7. The battery management apparatus (10, 20, 30, 40, 50, 60, 100) of claim 1, wherein the controller (120) is further configured to:
receive a third signal comprising voltage, current, and temperature information from the battery cell (11-16, 200); and
diagnose the state of the battery cell (11-16, 200) based on the second signal and the third signal.

8. The battery management apparatus (10, 20, 30, 40, 50, 60, 100) of claim 1, wherein the communication unit (110) is further configured to transmit the first signal when communication with the battery cell monitoring device (70) is not performed.

9. The battery management apparatus (10, 20, 30, 40, 50, 60, 100) of claim 1, wherein the communication unit (110) is further configured to transmit the first signal when the switch (130) is connected to the battery cell (11-16, 200).

10. The battery management apparatus (10, 20, 30, 40, 50, 60, 100) of claim 1, wherein the communication unit (110) is further configured to perform wireless communication with a battery cell monitoring device (70) through a radio frequency (RF) signal.

11. The battery management apparatus (10, 20, 30, 40, 50, 60, 100) of claim 10, wherein the communication unit (110) is further configured to perform the wireless communication when the switch (130) is connected to the antenna (140).

12. An operating method of a battery management apparatus (10, 20, 30, 40, 50, 60, 100), the operating method comprising:
transmitting, by a communication unit (110), a first signal to a battery cell (11-16, 200);
receiving, by a controller (120), a second signal corresponding to the first signal; and
diagnosing, by the controller (120), a state of the battery cell (11-16, 200) based on the second signal,
wherein the controller (120) is connected to the communication unit (110) through a switch (130), and
the switch (130) connects the communication unit (110) to the battery cell (11-16, 200);
wherein the method is **characterized by** further comprising:
controlling the operation of the switch (130) to allow the communication unit (110) to be connected to an antenna (140) when communication with a battery cell monitoring device (70) is performed; and
controlling the operation of the switch (130) to allow the communication unit (110) to be connected to the battery cell (11-16, 200) when communication with the battery cell monitoring device (70) is not performed.

13. The operating method of claim 12, wherein the diagnosing, by the controller (120), of the state of the battery cell (11-16, 200) based on the second signal comprises diagnosing the state of the battery cell (11-16, 200) by comparing the second signal with a signal related to a battery cell (11-16, 200) in a normal state.

## Patentansprüche

1. Batterieverwaltungsvorrichtung (10, 20, 30, 40, 50, 60, 100), umfassend:
eine Kommunikationseinheit (110), die konfiguriert ist, um ein erstes Signal an eine Batteriezelle (11-16, 200) zu übertragen;
einen Schalter (130), der konfiguriert ist, um die Kommunikationseinheit (110) mit der Batteriezelle (11-16, 200) zu verbinden; und
eine Steuerung (120), die konfiguriert ist, um einen Betrieb des Schalters (130) zu steuern, ein zweites Signal zu empfangen, das dem ersten Signal entspricht, und einen Zustand der Batteriezelle (11-16, 200) basierend auf dem zweiten Signal zu diagnostizieren,
**dadurch gekennzeichnet, dass** die Kommunikationseinheit (110) mit der Batteriezelle (11-16, 200) oder einer Antenne (140) basierend auf einem Betrieb des Schalters (130) verbunden ist,
wobei die Steuerung (120) ferner konfiguriert ist, um:
den Betrieb des Schalters (130) zu steuern, um zu ermöglichen, dass die Kommunikationseinheit (110) mit der Antenne (140) verbunden wird, wenn eine Kommunikation mit einer Batteriezellenüberwachungsvorrichtung (70) durchgeführt wird; und
den Betrieb des Schalters (130) zu steuern, um zu ermöglichen, dass die Kommunikationseinheit (110) mit der Batteriezelle (11-16, 200) verbunden wird, wenn keine Kommunikation mit der Batteriezellenüberwachungsvorrichtung (70) durchgeführt wird.

2. Batterieverwaltungsvorrichtung (10, 20, 30, 40, 50, 60, 100) nach Anspruch 1, wobei das erste Signal und das zweite Signal Hochfrequenz (HF)-Signale sind und das zweite Signal ein reflektiertes Signal des ersten Signals ist.

3. Batterieverwaltungsvorrichtung (10, 20, 30, 40, 50, 60, 100) nach Anspruch 1 oder 2, wobei die Steuerung (120) ferner konfiguriert ist, um den Zustand der Batteriezelle (11-16, 200) durch Vergleichen des zweiten Signals mit einem Signal zu diagnostizieren, das sich auf eine Batteriezelle (11-16, 200) in einem normalen Zustand bezieht.

4. Batterieverwaltungsvorrichtung (10, 20, 30, 40, 50, 60, 100) nach Anspruch 1, wobei die Kommunikationseinheit (110) ferner konfiguriert ist, um ein erstes Signal zu übertragen, das unterschiedliche Übertragungsleistungen umfasst, und
die Steuerung (120) ferner konfiguriert ist, um:
ein zweites Signal zu übertragen, das den unterschiedlichen Übertragungsleistungen entspricht; und
den Zustand der Batteriezelle (11-16, 200) basierend auf dem zweiten Signal zu diagnostizieren, das den unterschiedlichen Übertragungsleistungen entspricht.

5. Batterieverwaltungsvorrichtung (10, 20, 30, 40, 50, 60, 100) nach Anspruch 1, wobei die Kommunikationseinheit (110) ferner konfiguriert ist, um ein erstes Signal zu übertragen, das unterschiedliche Frequenzen umfasst, und
die Steuerung (120) ferner konfiguriert ist, um:
ein zweites Signal zu empfangen, das den unterschiedlichen Frequenzen entspricht; und
den Zustand der Batteriezelle (11-16, 200) basierend auf dem zweiten Signal zu diagnostizieren, das den unterschiedlichen Frequenzen entspricht.

6. Batterieverwaltungsvorrichtung (10, 20, 30, 40, 50, 60, 100) nach Anspruch 1, wobei die Steuerung (120) ferner konfiguriert ist, um mindestens eines von einer Impedanz, einer Empfindlichkeitsänderung, einer Spitzenfehlerraten (PER)-Änderung, einem Sättigungspegel und einer Empfangssignalstärkeanzeige (RSSI) der Batteriezelle (11-16, 200) basierend auf dem zweiten Signal zu diagnostizieren.

7. Batterieverwaltungsvorrichtung (10, 20, 30, 40, 50, 60, 100) nach Anspruch 1, wobei die Steuerung (120) ferner konfiguriert ist, um:
ein drittes Signal zu empfangen, das Spannungs-, Strom- und Temperaturinformationen von der Batteriezelle (11-16, 200) umfasst; und
den Zustand der Batteriezelle (11-16, 200) basierend auf dem zweiten Signal und dem dritten Signal zu diagnostizieren.

8. Batterieverwaltungsvorrichtung (10, 20, 30, 40, 50, 60, 100) nach Anspruch 1, wobei die Kommunikationseinheit (110) ferner konfiguriert ist, um das erste Signal zu übertragen, wenn keine Kommunikation mit der Batteriezellenüberwachungsvorrichtung (70) durchgeführt wird.

9. Batterieverwaltungsvorrichtung (10, 20, 30, 40, 50, 60, 100) nach Anspruch 1, wobei die Kommunikationseinheit (110) ferner konfiguriert ist, um das erste Signal zu übertragen, wenn der Schalter (130) mit der Batteriezelle (11-16, 200) verbunden ist.

10. Batterieverwaltungsvorrichtung (10, 20, 30, 40, 50, 60, 100) nach Anspruch 1, wobei die Kommunikationseinheit (110) ferner konfiguriert ist, um eine drahtlose Kommunikation mit einer Batteriezellenüberwachungsvorrichtung (70) durch ein Hochfrequenz(HF)-Signal durchzuführen.

11. Batterieverwaltungsvorrichtung (10, 20, 30, 40, 50, 60, 100) nach Anspruch 10, wobei die Kommunikationseinheit (110) ferner konfiguriert ist, um die drahtlose Kommunikation durchzuführen, wenn der Schalter (130) mit der Antenne (140) verbunden ist.

12. Betriebsverfahren einer Batterieverwaltungsvorrichtung (10, 20, 30, 40, 50, 60, 100), wobei das Betriebsverfahren umfasst:
Übertragen, durch eine Kommunikationseinheit (110), eines ersten Signals an eine Batteriezelle (11-16, 200);
Empfangen, durch eine Steuerung (120), eines zweiten Signals, das dem ersten Signal entspricht; und
Diagnostizieren, durch die Steuerung (120), eines Zustands der Batteriezelle (11-16, 200) basierend auf dem zweiten Signal,
wobei die Steuerung (120) mit der Kommunikationseinheit (110) durch einen Schalter (130) verbunden ist, und
der Schalter (130) die Kommunikationseinheit (110) mit der Batteriezelle (11-16, 200) verbindet;
wobei das Verfahren **dadurch gekennzeichnet ist, dass** es ferner umfasst:
Steuern des Betriebs des Schalters (130), um zu ermöglichen, dass die Kommunikationseinheit (110) mit einer Antenne (140) verbunden wird, wenn eine Kommunikation mit einer Batteriezellenüberwachungsvorrichtung (70) durchgeführt wird; und
Steuern des Betriebs des Schalters (130), um zu ermöglichen, dass die Kommunikationseinheit (110) mit der Batteriezelle (11-16, 200) verbunden wird, wenn keine Kommunikation mit der Batteriezellenüberwachungsvorrichtung (70) durchgeführt wird.

13. Betriebsverfahren nach Anspruch 12, wobei das Diagnostizieren, durch die Steuerung (120), des Zustands der Batteriezelle (11-16, 200) basierend auf dem zweiten Signal das Diagnostizieren des Zustands der Batteriezelle (11-16, 200) durch Vergleichen des zweiten Signals mit einem Signal umfasst, das sich auf eine Batteriezelle (11-16, 200) in einem normalen Zustand bezieht.

## Revendications

1. Appareil de gestion de batterie (10, 20, 30, 40, 50, 60, 100) comportant :
une unité de communication (110) configurée pour transmettre un premier signal à un élément de batterie (11-16, 200) ;
un commutateur (130) configuré pour connecter l'unité de communication (110) à l'élément de batterie (11-16, 200) ; et
un dispositif de commande (120) configuré pour commander le fonctionnement du commutateur (130), recevoir un deuxième signal correspondant au premier signal, et diagnostiquer un état de l'élément de batterie (11-16, 200) sur la base du deuxième signal,
**caractérisé en ce que** l'unité de communication (110) est connectée à l'élément de batterie (11-16, 200) ou à une antenne (140) sur la base du fonctionnement du commutateur (130),
dans lequel le dispositif de commande (120) est par ailleurs configuré pour :
commander le fonctionnement du commutateur (130) pour permettre à l'unité de communication (110) d'être connectée à l'antenne (140) quand une communication avec un dispositif de surveillance d'élément de batterie (70) est effectuée ; et
commander le fonctionnement du commutateur (130) pour permettre à l'unité de communication (110) d'être connectée à l'élément de batterie (11-16, 200) quand une communication avec le dispositif de surveillance d'élément de batterie (70) n'est pas effectuée.

2. Appareil de gestion de batterie (10, 20, 30, 40, 50, 60, 100) selon la revendication 1, dans lequel le premier signal et le deuxième signal sont des signaux de radiofréquence (RF), et le deuxième signal est un signal réfléchi du premier signal.

3. Appareil de gestion de batterie (10, 20, 30, 40, 50, 60, 100) selon la revendication 1 ou la revendication 2, dans lequel le dispositif de commande (120) est par ailleurs configuré pour diagnostiquer l'état de l'élément de batterie (11-16, 200) en comparant le deuxième signal à un signal lié à un élément de batterie (11-16, 200) dans un état normal.

4. Appareil de gestion de batterie (10, 20, 30, 40, 50, 60, 100) selon la revendication 1, dans lequel l'unité de communication (110) est par ailleurs configurée pour transmettre un premier signal qui comporte différentes puissances de transmission, et
le dispositif de commande (120) est par ailleurs configuré pour :
transmettre un deuxième signal correspondant aux différentes puissances de transmission ; et
diagnostiquer l'état de l'élément de batterie (11-16, 200) sur la base du deuxième signal correspondant aux différentes puissances de transmission.

5. Appareil de gestion de batterie (10, 20, 30, 40, 50, 60, 100) selon la revendication 1, dans lequel l'unité de communication (110) est par ailleurs configurée pour transmettre un premier signal qui comporte différentes fréquences, et
le dispositif de commande (120) est par ailleurs configuré pour :
recevoir un deuxième signal correspondant aux différentes fréquences ; et
diagnostiquer l'état de l'élément de batterie (11-16, 200) sur la base du deuxième signal correspondant aux différentes fréquences.

6. Appareil de gestion de batterie (10, 20, 30, 40, 50, 60, 100) selon la revendication 1, dans lequel le dispositif de commande (120) est par ailleurs configuré pour diagnostiquer au moins l'un quelconque parmi une impédance, un changement de sensibilité, un changement de taux d'erreur de crête (PER), un niveau de saturation, et une indication d'intensité du signal reçu (RSSI) de l'élément de batterie (11-16, 200) sur la base du deuxième signal.

7. Appareil de gestion de batterie (10, 20, 30, 40, 50, 60, 100) selon la revendication 1, dans lequel le dispositif de commande (120) est par ailleurs configuré pour :
recevoir un troisième signal comportant des informations de tension, de courant et de température en provenance de l'élément de batterie (11-16, 200) ; et
diagnostiquer l'état de l'élément de batterie (11-16, 200) sur la base du deuxième signal et du troisième signal.

8. Appareil de gestion de batterie (10, 20, 30, 40, 50, 60, 100) selon la revendication 1, dans lequel l'unité de communication (110) est par ailleurs configurée pour transmettre le premier signal quand une communication avec le dispositif de surveillance d'élément de batterie (70) n'est pas effectuée.

9. Appareil de gestion de batterie (10, 20, 30, 40, 50, 60, 100) selon la revendication 1, dans lequel l'unité de communication (110) est par ailleurs configurée pour transmettre le premier signal quand le commutateur (130) est connecté à l'élément de batterie (11-16, 200).

10. Appareil de gestion de batterie (10, 20, 30, 40, 50, 60, 100) selon la revendication 1, dans lequel l'unité de communication (110) est par ailleurs configurée pour effectuer une communication sans fil avec un dispositif de surveillance d'élément de batterie (70) par le biais d'un signal de radiofréquence (RF).

11. Appareil de gestion de batterie (10, 20, 30, 40, 50, 60, 100) selon la revendication 10, dans lequel l'unité de communication (110) est par ailleurs configurée pour effectuer la communication sans fil quand le commutateur (130) est connecté à l'antenne (140).

12. Procédé de fonctionnement d'un appareil de gestion de batterie (10, 20, 30, 40, 50, 60, 100), le procédé de fonctionnement comportant les étapes consistant à :
transmettre, par une unité de communication (110), un premier signal à un élément de batterie (11-16, 200) ;
recevoir, par un dispositif de commande (120), un deuxième signal correspondant au premier signal ; et
diagnostiquer, par le dispositif de commande (120), un état de l'élément de batterie (11-16, 200) sur la base du deuxième signal,
dans lequel le dispositif de commande (120) est connecté à l'unité de communication (110) par le biais d'un commutateur (130), et
le commutateur (130) connecte l'unité de communication (110) à l'élément de batterie (11-16, 200) ;
dans lequel le procédé est **caractérisé en ce qu'**il comporte par ailleurs les étapes consistant à :
commander le fonctionnement du commutateur (130) pour permettre à l'unité de communication (110) d'être connectée à une antenne (140) quand une communication avec un dispositif de surveillance d'élément de batterie (70) est effectuée ; et
commander le fonctionnement du commutateur (130) pour permettre à l'unité de communication (110) d'être connectée à l'élément de batterie (11-16, 200) quand une communication avec le dispositif de surveillance d'élément de batterie (70) n'est pas effectuée.

13. Procédé de fonctionnement selon la revendication 12, dans lequel l'étape consistant à diagnostiquer, par le dispositif de commande (120), l'état de l'élément de batterie (11-16, 200) sur la base du deuxième signal comporte l'étape consistant à diagnostiquer l'état de l'élément de batterie (11-16, 200) en comparant le deuxième signal à un signal lié à un élément de batterie (11-16, 200) dans un état normal.
